Europäisches Patentamt

European Patent Office

Office européen des brevets

(11) Publication number: 0 354 392 A1

# EUROPEAN PATENT APPLICATION

(21) Application number: 89113240.9

(22) Date of filing: 19.07.89

(51) Int. Cl.⁴: B23K 35/26 , H05K 3/34

(30) Priority: 29.07.88 JP 190145/88

(43) Date of publication of application:
14.02.90 Bulletin 90/07

(84) Designated Contracting States:
DE FR GB

(71) Applicant: HITACHI, LTD.
6, Kanda Surugadai 4-chome Chiyoda-ku
Tokyo(JP)

(72) Inventor: Harada, Masahide
Hitachi-jonan-Haitsu 5-3-7 Jonan
Fujisawa-shi Kanagawa-ken 251(JP)
Inventor: Satoh, Ryohei
Mezon-totsuka 403 6-1 Naze-cho Totsuka-ku
Yokohama-shi Kanagawa-ken 245(JP)
Inventor: Oshima, Muneo
Kosumo-totsuka-riberahiruzu A-1005
2767-55 Iijima-cho Sakae-ku
Yokohama-shi Kanagawa-ken 244(JP)
Inventor: Kobayashi, Fumiyuki
5-13 Asahi-cho
Sagamihara-shi Kanagawa-ken 228(JP)
Inventor: Takenaka, Takaji
1523-6 Hirasawa
Hatano-shi Kanagawa-ken 257(JP)
Inventor: Netsu, Toshitada
742-6 Tokawa
Hatano-shi Kanagawa-ken 259-13(JP)
Inventor: Shirai, Mitugu
338-3 Horiyamashita
Hatano-shi Kanagawa-ken 259-13(JP)
Inventor: Sasaki, Hideaki
1127-14 Imaizumi
Hatano-shi Kanagawa-ken 257(JP)

(74) Representative: Altenburg, Udo, Dipl.-Phys. et al
Patent- und Rechtsanwälte
Bardehle-Pagenberg-Dost-Altenburg
Frohwitter-Geissler & Partner Galileiplatz 1
Postfach 86 06 20
D-8000 München 86(DE)

(54) Solder and an electronic circuit using the same.

(57) A solder capable of forming bonds having improved reliability, and an electronic circuit device using such a solder for connecting the component parts thereof. The solder contains Pb, Sb, Ag and Sn in a composition capable of suppressing the low-temperature transformation of the Sn contained therein, suppressing the migration of the Ag contained therein, preventing the development and growth of Sn whiskers, and preventing corrosion.

FIG. 1

## SOLDER AND AN ELECTRONIC CIRCUIT USING THE SAME

### BACKGROUND OF THE INVENTION

The present invention relates to a solder having an enhanced reliability in bonding performance, and an electronic circuit device using the same solder for connecting the component parts thereof.

An electronic circuit device proposed to enhance the computing speed and operating efficiency of a large-scale computer has the following construction.

Highly integrated semiconductor devices, i.e., LSI chips, are mounted on a circuit board and connected to the wiring of the circuit board by using minute solder balls. The LSI chips are covered with a cooling cap to obviate the destruction of the LSI chips due to overheat. Then, I/O pins for electrically and mechanically connecting the circuit board to an external circuit are bonded to the circuit board.

These bonds must have a high reliability in mechanical, electrical and chemical performance. To meet such a requirement, Sn-Pb solders have been widely used.

Recently, the complexity and component layers of the electronic circuit devices have been progressively increased. In sequentially connecting the component parts of the electronic circuit device, various solders differing from each other in melting point must be used respectively for different levels of bonding temperature. Particularly, in connecting the component parts at a bonding temperature in the range of 225 to 250° C, it is considered that a Sn-3.5Ag solder (a solder containing 3.5% by weight Ag and Sn for the rest) is appropriate in respect of melting point and bonding strength. This solder is described in Nippon Kinzoku Gakkai, "Metal Data Book", p.308, Maruzen, Jan. 30, 1984.

The Sn-3.5Ag solder, however, has disadvantages including the low-temperature transformation of Sn, the migration of Ag and the development and growth of Sn whiskers. Such disadvantages affects adversely to the reliability of bonds in the electronic circuit device.

Although different from the solder for the electronic circuit device in the field of application, J.P. Pub. Nos. 58-29198 and 58-29199 disclose a Sn-Ag solder containing Bi or In and capable of reducing current induced in soldered portions of superconducting wires.

A first disadvantage of the Sn-3.5Ag solder is the adverse influence of the low-temperature transformation of Sn on the performance of the Sn-3.5Ag solder. The metallic Sn ($\beta$-Sn) transforms into $\alpha$-Sn at a temperature not higher than 13° C. Practically, the transformation of the Sn becomes a significant problem in the temperature range of -40 to -50° C because the transformation velocity is low. $\alpha$-Sn is very brittle and develops in grey powder. When metallic Sn transforms into $\alpha$-Sn, the volume increases by 26%. Since the Sn content of the Sn-3.5Ag solder is high, it is possible that the low-temperature transformation of the Sn causes the solder bonds to fracture.

A second disadvantage of the Sn-3.5Ag solder is the migration of Ag. Most minute bonds of the electronic circuit devices are formed on a film formed by a metallizing process over the surface of a ceramic plate, and the surface of the ceramic plate is coated always with moisture. Some minute bonds of the electronic circuit device function as part of the electronic circuit device and electric fields are created around such minute bonds. Thus, the minute bonds are within an environment where migration is liable to occur. As is well known, Ag is a metal which is liable to migrate. When the Sn-3.5Ag is used for connecting the component parts of the electronic circuit device at the minute bonds, there is a possibility that the electronic circuit device is short-circuited by due to the migration of Ag owing to the foregoing reasons.

A third disadvantage of the Sn-3.5Ag solder is the development and growth of Sn whiskers. Sn whiskers are Sn crystals that develop spontaneously from a Sn surface. Some Sn crystals grow in whiskers of several millimeters long. Sn whiskers are liable to develop and grow from the Sn-3.5Ag solder having a high Sn content. The development and growth of Sn whiskers in the minute bonds of the electronic circuit device is a possible cause of short circuit.

A fourth disadvantage of the Sn-3.5Ag solder is corrosion. The component parts of the electronic circuit device are exposed often to heat of a high temperature spontaneously generated by the electronic circuit device, and it is possible that the solder bonds connecting the component parts are corroded and thereby the bonding strength of the solder bonds is deteriorated.

### SUMMARY OF THE INVENTION

Accordingly, it is a first object of the present invention to provide a solder free from the foregoing disadvantages, having high mechanical, electrical and chemical reliability and capable of being used in the bonding temperature range of 225 to 250°C.

It is a second object of the present invention to provide an electronic circuit device comprising electronic parts interconnected by such a solder and having high mechanical, electrical and chemical reliability.

The inventors of the present invention have found through researches on the effect of addition of other elements to the Sn-Ag solder to obtain a solder having high reliability for forming bonds having high reliability in connecting the component parts of the electronic circuit device that the object of the invention can be achieved by the addition of Sb and/or Pb to the conventional Sn-Ag solder (a Sn-Ag solder having an Ag content in the range of 2.0 to 8.0% by weight, particularly, a Sn-Ag solder having an Ag content around 3.5% by weight).

To achieve the objects, the present invention provides a solder containing from 0.01 to 2.0% by weight Pb and/or from 0.01 to 0.5% by weight Sb, from 2.0 to 8.0% by weight Ag, and Sn as the rest.

Ag improves the strength of the solder. To secure a sufficient strength, Ag content is at least 2.0% by weight. Sn and Ag forms a binary eutectic alloy. The Ag content of the binary eutectic alloy at the eutectic point is 3.5% by weight and the melting point is 221°C. To make the solder capable of being used in the bonding temperature range of 225 to 250°C, it was determined from the phase diagram of the Sn-Ag binary eutectic alloy that the upper limit of the Ag content is 8% by weight.

Addition of Sb and/or Pb to the Sn-Ag solder eliminates the foregoing four disadvantages; that is, the addition of Sb and/or Pb (1) suppresses the low-temperature transformation of Sn contained in the solder, (2) suppresses the migration of Ag contained in the solder, (3) prevents the development and growth of Sn whiskers, and (4) prevents the corrosion of the solder.

When a metal is alloyed with Sb or Pb to obtain an alloy, the hardness of the alloy is higher than that of the metal. Alloys having a Pb content over 2.0% by weight or a Sb content over 0.5% by weight are excessively brittle and hence such alloys unsuitable for use as solders. On the other hand, a Pb content or a Sb content under 0.01% by weight is ineffective in eliminating the foregoing disadvantages.

Although the solder of the present invention unavoidably contains impurities including C, N and O, the impurity content of the solder is 100 ppm or below.


## BRIEF DESCRIPTION OF THE DRAWINGS


Figure 1 is a perspective view of an electronic circuit device embodying the present invention;

Figure 2 is a perspective view of assistance in explaining a reliability evaluating test for detecting the low-temperature transformation of Sn in a solder;

Figure 3 is a perspective view of assistance in explaining a reliability evaluating test for detecting migration in a solder; and

Figure 4 is a perspective view of assistance in explaining a reliability evaluation test for detecting the development of Sn whiskers.


## DETAILED DESCRIPTION OF THE PREFERRED EMBODIMENTS


Test samples Nos. 1 to 6 of solders embodying the present invention were prepared by alloying 99.99% purity Sn, 99.99% purity Ag, 99.99% Pb and 99.99% purity Sb. The constituents of the test samples Nos. 1 to 3 are Sn, Ag and Pb, and those of the test samples Nos. 4 to 6 are Sn, Ag and Sb. The respective compositions of the test samples Nos. 1 to 6 are tabulated in Table 1.

Test samples Nos. 7 to 11 of known solders were prepared as controls by alloying 99.99% purity Sn, 99.99% purity Ag, 99.99% purity Pb, 99.99% purity Bi and 99.99% purity In. The constituents of the test samples Nos. 7 and 8 are Sn and Ag, those of the test sample No. 9 are Sn, Ag and Bi, those of the test sample No. 10 are Sn, Ag and In, and those of the test sample No. 11 are Sn and Pb. Although the test sample No. 11 is not of the Sn-Ag solder, the same was included in the test samples for reference. The respective compositions of the test samples Nos. 7 to 11 are tabulated also in Table 1.

The test samples were subjected to reliability evaluation tests to see if the solders of the present invention eliminates the foregoing disadvantages adversely affecting the bonding reliability.

**Table 1**

| | Sample Nos. | Composition (percent by weight) | | | | | |
|---|---|---|---|---|---|---|---|
| | | Pb | Sb | Bi | In | Ag | Sn |
| Solders embodying the Present invention | 1 | 0.50 | 0 | 0 | 0 | 3.48 | 96.02 |
| | 2 | 1.00 | 0 | 0 | 0 | 3.47 | 95.53 |
| | 3 | 1.50 | 0 | 0 | 0 | 3.45 | 95.05 |
| | 4 | 0 | 0.10 | 0 | 0 | 3.50 | 96.40 |
| | 5 | 0 | 0.20 | 0 | 0 | 3.49 | 96.31 |
| | 6 | 0 | 0.30 | 0 | 0 | 3.49 | 96.31 |
| Known solders | 7 | 0 | 0 | 0 | 0 | 3.50 | 96.50 |
| | 8 | 0 | 0 | 0 | 0 | 5.00 | 95.00 |
| | 9 | 0 | 0 | 0.50 | 0 | 3.48 | 96.02 |
| | 10 | 0 | 0 | 0 | 0.50 | 3.48 | 96.02 |
| | 11 | 37.00 | 0 | 0 | 0 | 0 | 63.00 |

Minute balls of 0.3 mm in diameter and foils of 0.6 mm in thickness of the solders having compositions shown in Table 1 were prepared for experiments. The balls and foils of the test sample No. 11 (a generally used Sn-37Pb eutectic alloy) were tested for comparison together with the rest of the test samples.

Experiment 1: Low-temperature Transformation of Sn

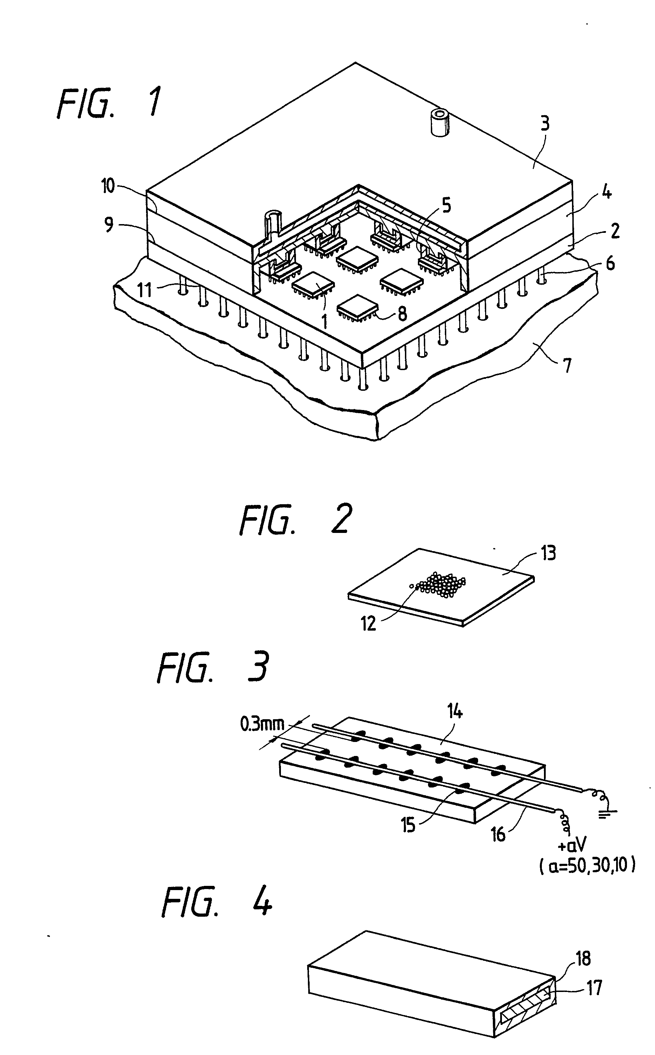

Solder balls 12 of each of the test samples No. 1 to 11 were spread in a layer in an area of about 1 cm² on each of three ceramic plates 13 as shown in Fig. 2. The three ceramic plates were left for a predetermined time respectively in cryostats of -60°C, -35°C and -10°C. Then, the balls were examined by X-ray diffraction analysis for the existence of α-Sn attributable to the low-temperature transformation of Sn.

Experiment 2: Migration

A W/Ni/Au film was formed in a pattern on each of three ceramic plates 14 by a metallizing process, the three foils of each of test samples No. 1 to 11 cut in the pattern of the S/Ni/Au film were placed on the ceramic plates 14, fine Cu wires 16 were placed 16 across the patterns of the foils as shown in Fig. 3, and then the ceramic plates 14 were heat-treated at 240°C. Then, 10 V dc, 30 V dc and 50 V dc were applied across the fine Cu wires 16 in a thermohygrostat conditioned at 85°C and 85% RH to measure time elapsed before short circuit occurred due to migration.

Experiment 3: Development of Whiskers

Cu plates 17 of 100 mm × 20 mm × 5 mm were dipped respectively in molten solders of test samples Nos. 1 to 11 to coat the Cu plates 17 with the solders as shown in Fig. 4. The solder-coated Cu plates were left for a predetermined time in a thermostatic chamber conditioned at 50°C. The surfaces of the solder-coated Cu plates 17 were observed with a scanning electron microscope.


Experiment 4: Corrosion

The same test pieces as those for the Experiment 1 were prepared. The test pieces were left for a predetermined time in a thermohygrostat conditioned at 85°C and 85% RH, and then the surface of the test pieces were observed with a scanning electron microscope for corrosion. The weight of the solder balls were measured before and after the test to measure the variation of weight due to corrosion.

Results of Experiments 1 to 4 are tabulated in Table 2.

As is evident from Table 2, transformation did not occur in any of the test samples Nos. 1 to 6 (embodiments) in 10,000 hours at -10°C, -30°C and -60°C, transformation occurred in the test sample No. 7 (control) in 8,000 hours at -60°C and in the test sample No. 8 (control) in 9,000 hours at -60°C. Transformation did not occur in 10,000 hours in the rest of the test samples.


Table 2

| Sample Nos. | Low-temp. transformation Time (hr) | | | Migration Time (hr) | | | Whisker Time (hr) | Corrosion Wt. reduction (%) in 5000 hrs |
|---|---|---|---|---|---|---|---|---|
| | | | | 85°C, 85% RH | | | | |
| | -60°C | -35°C | -10°C | 50 V | 30 V | 10 V | 50°C | 85°C, 85% RH |
| 1 | - | - | - | - | - | - | - | 0 |
| 2 | - | - | - | - | - | - | - | 0 |
| 3 | - | - | - | - | - | - | - | 0 |
| 4 | - | - | - | - | - | - | - | 0 |
| 5 | - | - | - | - | - | - | - | 0 |
| 6 | - | - | - | - | - | - | - | 0 |
| 7 | 8000 | - | - | 9500 | - | - | 7000 | 1.0 |
| 8 | 9000 | - | - | 9000 | - | - | 7000 | 1.0 |
| 9 | - | - | - | 8000 | - | - | - | 0.1 |
| 10 | - | - | - | 8500 | - | - | - | 0.1 |
| 11 | - | - | - | - | - | - | - | 5.0 |
| Note: Mark "-" indicates that low-temperature transformation of Sn did not occur in 10,000 hours, no migration occurred in 10,000 hours or no whisker developed. | | | | | | | | |


Short circuit attributable to migration did not occur in any of the test samples Nos. 1 to 6 (embodiments) in 10,000 hours at 10 V, 30 V and 50 V. Short circuit occurred in the test samples Nos. 7, 8, 9 and 10 at 50 V respectively in 9,500 hours, 9,000 hours, 8,000 hours and 8,500 hours. At 10 V and 30 V, short circuit occurred in none of the test samples in 10,000 hours. Short circuit did not occur in the test sample No. 11 in 10,000 hours at all the voltage levels.

Whiskers developed in none of the test samples Nos. 1 to 6 (embodiments) in 10,000 hours. Whiskers developed in the test samples Nos. 7 an 8 (controls) in 7,000 hours. Whiskers did not develop in test samples Nos. 9, 10 and 11 in 10,000 hours.

None of the test samples Nos. 1 to 6 was corroded and did not change in weight in 5,000 hours. The test samples Nos. 7 to 11 were corroded in 5,000 hours, and the respective weights of the test pieces of the test samples Nos. 7 to 11 were reduced respectively by 1.0%, 1.0%, 0.1%, 0.1% and 5.0%.

As is obvious from the foregoing experimental results, no problem attributable to the low-temperature transformation of Sn, migration, whiskers and corrosion occurs in the solders embodying the present invention in a long time, whereas the known solders tested as controls have problems attributable to some or all of the foregoing causes. Thus, the solders of the present invention have excellent reliability as compared with the known solders tested as controls, and hence the electronic circuit device using the solders of the present invention for connecting the component parts has excellent bonding reliability.

An electronic circuit comprising component parts connected by the solder embodying the present invention will be described hereinafter.

Fig. 1 shows schematically an electronic circuit device in a preferred embodiment according to the present invention comprising a plurality of LSI chips 1 connected to the circuit patterns formed in a multilayer ceramic circuit board 2 by using minute solder balls of 1.0% by weight Pb, 3.475 by weight Ag and 95.53% by weight Sn.

The LSI chips 1 are disposed in a predetermined arrangement on the multilayer ceramic circuit board 2; heat transfer members 5 are placed in contact with the LSI chips 1; the heat transfer members 5 are covered with a cap 4; a cooling plate 3 is placed on the cap 4. The circuit patterns of the multilayer ceramic circuit board 2 are bonded to I/O pins 6 provided on a wiring board 7 to construct the electronic circuit device.

In fabricating the electronic circuit device by assembling the multilayer ceramic circuit board 2, the cooling plate 3, the cap 4, the heat transfer members 5, the I/O pins 6 and the wiring board 7, minute solder balls of 1.0% by weight Pb, 3.47% by weight Ag and 95.35% by weight Sn, a solder 9 of 37.0% by weight Pb and 63.0% by weight Sn, a solder 10 of 98.0% by weight Pb and 2.0% by weight Sn, and a silver solder 11 of 72.0% by weight AG and 28.0% by weight Cu are used.

The multilayer ceramic circuit board 2 is placed on the wiring board 7 with the silver solder 11 placed between the backside of the multilayer ceramic circuit board 2 and the tips of the I/O pins 6, and then the combination of the multilayer ceramic circuit board 2 and the wiring board 7 is subjected to a heat treatment, in which the combination is heated at 800°C and cooled, to bond the circuit patterns of the multilayer ceramic circuit board 2 to the I/O ping 6.

Then, the LSI chips 1 are placed on the surface of the multilayer ceramic circuit board 2 with the minute solder balls 8 provided therebetween, and then the LSI chips 1 are bonded to the multilayer ceramic circuit board 2 by a heat treatment in which the solder balls 8 are heated at 240°C.

The cooling plate 3 is placed on the cap 4 with the solder 10 therebetween, and then the combination of the cooling plate 3 and the cap 4 is heated at 340°C to join together the cooling plate 3 and the cap 4.

After placing the heat transfer members 5 on the LSI chips 1 bonded to the circuit patterns of the multilayer ceramic circuit board 2, the assembly of the cooling plate 3 and the cap 4 is placed on the multilayer ceramic circuit board 2 with the solder 9 spread between the periphery of the multilayer ceramic circuit board 2 and the corresponding periphery of the cap 4, and then the multilayer ceramic circuit board 2 and the cap 4 are joined together by heating the solder 9 at 200°C.

The present invention is not limited in application to the foregoing embodiment and various modifications are possible therein. For example, in constructing the electronic circuit device of Fig. 1, the solder of the present invention maybe used instead of the solder 9 or 10. However, appropriate solders must be selected properly taking into consideration the bonding temperature. The constituents of the electronic circuit device of the present invention are not limited to those shown in Fig. 1.

As is apparent from the foregoing description, the solder in accordance with the present invention has the following advantages over the conventional Sn-Ag solders.

(1) The Sn contained in the solder is hardly subject to low-temperature transformation.

(2) Migration occurs hardly in the solder.

(3) Whiskers develop hardly in the solder.

(4) The solder is highly resistant to corrosion.

Furthermore, the electronic circuit device comprising component parts interconnected by the solder of the present invention has high mechanical, electrical and chemical reliability.

## Claims

1. A solder containing:
both from 0.01 to 2.0% by weight Pb and from 0.01 to 0.5% by weight Sb or either from 0.01 to 2.0% by weight Pb or from 0.01 to 0.5% by weight Sb;
from 2.0 to 8.0% by weight Ag; and
Sn for the rest.

2. An electronic circuit device having parts bonded by solders containing:

both from 0.01 to 2.0% by weight Pb and from 0.01 to 0.5% by weight Sb or either from 0.01 to 2.0% by weight Pb or from 0.01 to 0.5% by weight Sb;
from 2.0 to 8.0% by weight Ag; and
Sn for the rest.

3. An electronic circuit device according to Claim 2, wherein the component parts connected by the solders are connected by heat treatment in order of the melting point of the solders.

4. An electronic circuit device according to Claim 3 comprises: a wiring board; I/O pins inserted in the wiring board; a multilayer circuit board electrically connected to the I/O pins; semiconductor devices mounted on the multilayer circuit board; a cap covering the semiconductor devices; and a cooling plate placed on the cap.

5. An electronic circuit device according to Claim 4, wherein said cap and said multilayer circuit board are bonded together by a Pb-Sn solder.

6. An electronic circuit device according to Claim 4, wherein said cooling plate and said cap are bonded together by a Pb-Sn solder.

7. An electronic circuit device according to Claim 4, wherein said I/O pins are bonded to the circuit patterns of said multilayer circuit board by a silver solder.

8. A solder containing Pb and/or Sb, Ag and Sn, and having a composition capable of suppressing the low-temperature transformation of Sn, suppressing the migration of Ag, preventing the development and growth of Sn whiskers, and preventing corrosion.

9. An electronic circuit device having parts bonded by solders containing Pb and/or Sb, Ag and Sn, and each having a composition capable of suppressing the low-temperature transformation of Sn, suppressing the migration of Ag, preventing the development and growth of Sn whiskers, and preventing corrosion.

10. An electronic circuit device according to Claim 9, wherein the component parts connected by the solders are connected by heat treatment in order of the melting point of the solders.

11. An electronic circuit device according to Claim 10 comprises: a wiring board; I/O pins inserted in the wiring board; a multilayer circuit board having circuit patterns electrically connected to the I/O pins; semiconductor devices mounted on the multilayer circuit board; a cap covering the semiconductor devices; and a cooling plate placed on the cap.

12. An electronic circuit device according to Claim 11, wherein said cap and said multilayer circuit board are bonded together by a Pb-Sn solder.

13. An electronic circuit device according to Claim 11, wherein said cooling plate and said cap are bonded together by a Pb-Sn solder.

14. An electronic circuit device according to Claim 1, wherein said I/O pins are bonded to the circuit patterns of said multilayer circuit board by a silver solder.

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | DE-A-1 589 543 (ROBERT BOSCH)<br>* Claims 1,5-7 *<br>--- | 1,2,8,9 | B 23 K 35/26<br>H 05 K 3/34 |
| X | WO-A-8 303 216 (WESTERN ELECTRIC)<br>* Claims 1,5; figures *<br>--- | 8,9 | |
| X | US-A-4 739 917 (J.D. BAKER)<br>* Claims; column 3, lines 34-40 *<br>--- | 8,9 | |
| X | US-A-4 170 472 (D.R. OLSEN et al.)<br>* Column 2; table *<br>--- | 8,9 | |
| A | US-A-3 607 253 (J.F. CAIN et al.)<br>--- | | |
| A | FR-A- 862 549 (J. SCHMIT et al.)<br>--- | | |
| A | PATENT ABSTRACTS OF JAPAN, vol. 6, no. 50 (M-120)[928], 3rd April 1982; & JP-A-56 165 588 (AOKI METARU K.K.) 19-12-1981<br>--- | | TECHNICAL FIELDS SEARCHED (Int. Cl.5) |
| A | IBM TECHNICAL DISCLOSURE BULLETIN, vol. 23, no. 8, January 1981, page 3620, New York, US; O.I. CHIRINO et al.: "High creep strength alloy"<br>----- | | B 23 K<br>H 05 K |

The present search report has been drawn up for all claims

| Place of search | Date of completion of the search | Examiner |
|---|---|---|
| THE HAGUE | 10-11-1989 | MOLLET G.H.J. |

EPO FORM 1503 03.82 (P0401)